(19) Europäisches Patentamt
European Patent Office
Office européen des brevets

(11) **EP 3 525 563 A1**

(12) **EUROPEAN PATENT APPLICATION**

(43) Date of publication:
**14.08.2019 Bulletin 2019/33**

(51) Int Cl.:
**H05K 7/20** (2006.01)  **G06F 1/20** (2006.01)
**G06F 9/50** (2006.01)

(21) Application number: **18155578.0**

(22) Date of filing: **07.02.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(71) Applicant: **ABB Schweiz AG**
**5400 Baden (CH)**

(72) Inventors:
• **MISHCHENKO, Kateryna**
**72242 Västerås (SE)**

• **GARCIA-GABIN, Winston**
**169 72 Solna (SE)**
• **ZHANG, Xiaojing**
**722 10 Västerås (SE)**
• **SVENSSON, Stefan**
**13439 Gustavsberg (SE)**

(74) Representative: **Lundqvist, Alida Maria Therése**
**ABB AB**
**Intellectual Property**
**Forskargränd 7**
**721 78 Västerås (SE)**

(54) **METHOD AND SYSTEM FOR CONTROLLING POWER CONSUMPTION OF A DATA CENTER BASED ON LOAD ALLOCATION AND TEMPERATURE MEASUREMENTS**

(57) The present invention relates to a system (1) for controlling power consumption of a data center comprising a plurality of server units (4) disposed in an area (3), and a cooling system (6) for cooling the server units, and a plurality of temperature sensors (14) distributed in the area. The system comprises a data storage (22) for storing workload profiles for tasks executed on the server units, a computing unit (24) configured to receive temperature measurements from the temperature sensors, to receive current workload for one or more of the server units, and to perform a multi-objective optimization including simultaneously optimizing the total power consumption of the cooling system, optimizing allocation of the workload on the server units, and optimizing the thermal conditions for the server units based on the temperature measurements, the current workload on the server units, the workload profiles, constraints for load allocation of the server units, and limitations of allowed temperatures at the server units. The system (1) is configured to perform closed loop control of the cooling system (6) and the workload on the server units (4) based on the result of the multi-objective optimization.

Fig. 1a

**EP 3 525 563 A1**

**Description**

Technical field

The present invention relates to a method and a system for controlling power consumption of a data center, the data center comprising server units and a cooling system for cooling the server units.

Background

A data center is a facility used to house server units. A data center has a plurality of rows of racks, where each rack includes a large amount of server units. The server units produce large amount of energy causing heating of the room housing the server units. Since the electronics of the server units are sensitive to high temperatures, the data center is provided with a cooling system for cooling down the server units. The cooling system includes a cooling unit producing cold air or liquid and a distribution net for distributing the cold air/liquid to the racks including the server units. Today, data centers are often provided with a computer room air conditioning (CRAC) unit, which is a device that monitors and maintains the temperature, air distribution and humidity in a network room or data center. CRAC units are now replacing air-conditioning units that were used in the past to cool data centers.

A problem is that cooling of a large data center requires much power. A large data center in an industrial-scale operation can use as much electricity as a small town. Almost half of the total electrical power is consumed by the cooling system; which is indispensable for safe operation of the servers.

The servers generate heat according to their power consumption. There is a close connection between the power consumption of the servers and the temperature in the server area. Further, the power consumed by the server units depends on the workload on the server units; and accordingly, the heat generated by the server units depends on the workload of the server units. Thus, increased workload leads to an increased need of cooling the server units and accordingly increases the power consumption of the cooling system.

There are significant non-uniformities of temperature distribution in data centers. Hot spots and overcooling are common in data centers due to workload variations and limitation to the controllability of the cooling. The conventional way to manage the data center is to consider the workload as unmeasured disturbance of the data center. Thus, the operator aims to avoid hot spots and overcooling in the data center by manually changing the cooling power supplied for the cooling equipment to the data center room for dynamic changes on the workload. This way of manual control has a strong controllability limitation due to the inability to adjust individual cooling power for each server or server-rack. Most of the data centers have a plenum, where the cold air is supplied by the cooling equipment, or in the case of liquid cooling, a network of pipes is used to supply the cooling liquid to refrigerate servers or server racks. In the case that the servers or server-racks that are working at high demand level of workload are surrounded by a group of servers or server-racks in idle status, it is impossible to avoid hot spots without overcooling the idle servers.

In an article "Optimization of IT load and facility energy in data centers" written by Kunio Fukumoto, Nobuyuki Tamura, and Hideki Ishibashi published in Fujitsu Sci, Tech, J., vol. 46, No. 4, pp. 376 - 382 (October 2010), it is proposed to monitor the temperature and air flow around the racks and the electric power consumed for each rack in the data center and to optimize the power required for the cooling of the data center based on the monitored parameters. The electric power and environmental conditions of the servers are monitored and used to improve the efficiency of the power and air conditioning facilities. The air conditioners are run in accordance with the current workload to reduce the power needed for cooling the data center. The electric power and environmental information, such as the temperature for each rack, is displayed to the operators in the form of graphs. The amount of cool air required by each row of racks are displayed to allow the operators to visualize the optimum state of the air conditioner operation.

Another article, "Reducing data center energy consumption via coordinated cooling and load management" written by Luca Parolino, Bruno Sinopoli, and Bruce H. Krogh, HotPower'08 Proceedings of the 2008 conference on Power aware computing and systems, from 7 December 2008, also discusses solutions to this problem. It is proposed to minimize the energy consumption taking into account the workload. This is done by usage of an integrated thermal and computational model. The data center is modelled as two coupled networks: a computational network and a thermal network. Each node in the thermal network has an input temperature and an output temperature. The proposed data center model has three sets of controllable parameters: the computational network workload exchange, the server node power status and reference temperature of the cooling system. The power consumption of the server nodes or the power consumption of the whole data center is optimized by building a constrained Markov decision process based on the data center model. Constraints to the optimization problem are maximum and minimum temperatures for the server nodes. The optimization problem is solved with the objective to minimize the power consumption of the cooling system and by enforcing the thermal constraints. Each server in the node has different input temperature according to the flow dynamic interaction between the airflow and temperature of the air conditioning units. A disadvantage with this method is that it is difficult to measure the input and output temperatures of the nodes.

Summary

It is an aim of the present invention to provide an improved method for reducing the power consumption of a data center, the data center comprising a plurality of server units disposed in an area and a cooling system for cooling the server units.

This aim is achieved by a method for controlling power consumption of a data center as defined in claim 1.

The method comprises:

- storing workload profiles for tasks executed on the server units,
- receiving temperature measurements from a plurality of temperature sensors distributed in the area,
- receiving current workload for one or more of the server units,
- performing a multi-objective optimization including simultaneously optimizing the total power consumption of the cooling system, optimizing allocation of the workload on the server units, and optimizing the thermal conditions for the server units based on the temperature measurements, the current workload on the server units, the workload profiles, constraints for load allocation of the server units, and limitations of allowed temperatures at the server units, and
- performing closed loop control of the cooling system and the workload on the server units based on the result of the multi-objective optimization.

The present invention makes it possible to allocate workload to the server units so that the total energy consumption for cooling the server units is reduced. For example, during night the workload on the server units is low for certain types of applications, and only a few server units are executing tasks when the other server units are idle or have low workload. If the total workload of the data center is moved to a few server units located adjacent to each other, only a small area of the data center needs cooling. The other areas of the data center will not require any cooling, and thus will not consume any cooling energy. This is achieved by performing a multi-objective optimization based on temperature measurements in the area of the data center, the current workload on the server units, the workload profiles, constraints for load allocation of the server units, and limitations of allowed temperatures at the server units. The multi-objective optimization ca also be based on the geometry of the data center, such as the position of servers and cooling unit.

With workload is meant the load on a processing unit, such as a CPU, of the server unit when executing tasks. The workload can also be denoted CPU load, processing load or IT load. The workload is usually given as a percentage of the maximum possible load on the processing unit of the server unit. For example, an idle server unit has a load of 0%, and a fully utilized server unit has a workload of 100%. The current workload is a measure of how busy the server unit is at the moment.

The terms "server" and "server unit" are used interchangeably throughout the disclosure.

A workload profile for a task is defined as the workload on the server unit during the execution of the task on the server unit. The workload profiles extend over a period of time, and may include variations in the workload during the day or week. For example, for some tasks the workload is higher during the day than in the night, or vice versa. The workload can also vary over the week. For example, the workload for some tasks is higher during working days than during weekends, or vice versa. Preferably, the workload profiles cover the workload for at least 24 hours, and more preferably during a longer time, such as at least a week. The workload profiles can be determined beforehand, i.e. before executing the multi-objective optimization. For example, the workload profiles can be based on the historical average workload on the server units during the execution of the tasks so that a profile comprises an average workload per time unit for the execution of a task. Alternatively, the workload profiles are determined based on predictions of the workload on the server units during the execution of the tasks. In an embodiment, the workload profiles can be repeatedly updated based on the actual workload on the server units executing the tasks.

Multi-objective optimization involves minimizing and/or maximizing multiple objective functions subject to a set of constraints. In this case, optimization of the total power consumption of the cooling system aims at minimizing the total power consumption.

Performing a multi-objective optimization includes solving a mathematical optimization problem involving more than one objective function to be optimized simultaneously. Often, these objective functions are conflicting, meaning that optimum with respect to one objective for a certain argument is suboptimum with respect to another objective. There exist several known approaches for how to solve the multi-objective optimization problem. For example, a posteriori approach is used. Thus, the solution to the multi-objective optimization problem is a Pareto front which includes a set of alternative Pareto optimal solutions to the problem. As a result, the total power consumption according to the selected Pareto optimal solution is not the minimal total power consumption comparing to the case if a single objective optimization problem with the objective of minimization of the power is solved. There may exist other solutions which provide lower total power consumption, but which are not selected due to the presence of better solutions with respect to other objectives.

According to the invention, the multi-objective optimization problem involves simultaneously optimizing the total power consumption of the cooling system, optimizing the workload on the server units, and optimizing the thermal conditions for the server units. Optimization of the workload allocation can be done regarding where and/or when the work load is allocated. Constraints to be considered when solving the multi-objective optimization problem are constraints for load allocation of the server units and limitations on the temperature at the server units. Reallocating workload may not always be allowed for all servers in the data center. Constraints for load allocation are limitations on the load allocation; e.g. dedication of certain servers to certain tasks. For example, some of the server units may be dedicated to execute certain tasks, and accordingly, workload on those server units cannot be reallocated. Constraints for the temperature are, for example, maximum and minimum allowed temperatures for the servers.

In order to solve the multi-objective optimization problem, the temperature measurements, the current workload on the server units and the workload profiles are used. Due to the workload profiles, the optimization takes into account variations in the workload over time, such as variations during day and night in order to minimize the total power consumption. Prediction abilities in the multi-objective optimization allow reallocating the workload both regarding where the workload is allocated and regarding when the servers are to perform the tasks associated with the workload, for minimizing the total power consumption.

The invention uses a feedback approach where actual output information, such as current thermal status, workload profiles and current work load on the server units, is used to run an optimization algorithm in order to determine a combination of inputs, such as temperature and airflow of the cooling unit, workload allocation and workload load shifting, when it is possible.

A closed loop control of the cooling system and the workload on the server units is carried out based on the result of the multi-objective optimization. Thus, parameters, such as output temperature, e.g. CRAC temperature, and flow rate of the cooling medium from the cooling system, are automatically adjusted in order to minimize the power consumption of the data center. Further, the workload on the server units is also automatically adjusted in order to minimize the power consumption of the data center. For example, the execution of tasks can be shifted from one server unit to another server unit. With increased use of virtual machines (VM) in data centers, it becomes easier to shift the workload from one server to another. Optimal workload allocation and shifting will allow to minimize the cooling power supply and as a result, minimize the total power consumption for the data center. A total power consumption is regarded as a combination of cooling and computing power.

This invention provides a new way to control data center thermal conditions based on workload and shifting of workload in addition to the fluid flow and temperature output of the cooling unit as decision variables for optimizing the total power consumption in data centers. Thermal status is used for minimization of cooling power by reallocation and/or shift of workload. Thus, servers with more efficient cooling will be allocated by a larger workload, which allows to minimize the total cooling power required. Further, the invention takes into account variations in the workload over time.

The invention can be used on both new and existing data centers and with different kinds of cooling technologies leading to increased efficiency of data center operations.

According to an aspect of the invention, the decision variables of the multi-objective optimization are output temperature, flow rate of the air/liquid flow output from the cooling unit and workload distribution on the server units. With workload distribution is meant how the tasks to be executed are distributed on the server units, i.e. on which one of the server units in the data center each task is to be executed. The multi-objective optimization will calculate optimal setting for the cooling system, as well as an optimal workload distribution in the data center both in space and time. The closed loop control of the cooling system controls the temperature and air/liquid flow from the cooling unit and the closed loop control of the workload on the server units controls the distribution of the workload on the server units. This will decrease the energy consumption in the data center.

According to an aspect of the invention, the closed loop control of the cooling system comprises automatically controlling temperature and flow rate of the cooling system based on the result of the multi-objective optimization.

According to an aspect of the invention, the method comprises calculating an optimal distribution of the workload on the server units based on the result of the multi-objective optimization, and the closed loop control of the workload comprises distribution of the workload on the servers based on the calculated optimal distribution of the workload. Redistribution of the workload on the servers means that the execution of tasks can be moved from one server unit to another server unit. For example, a task which is not dedicated to a specific server is scheduled to a server located in an area of a most efficient cooling. Thus, the optimization can take into account local variations in temperature and flow rate in different areas in the data center and the execution of tasks automatically scheduled to those areas of the data center that reduce the energy consumption. The task can also be performed in the same server unit but at a later time, or at another server unit at a different time.

According to an aspect of the invention, the closed loop control of the workload comprises providing optimal schedules for the workload on the server units for a time period ahead based on the result of the multi-objective optimization, and controlling the workload on server units based on the optimal schedules for the workload. With optimal schedules is meant schedules determined with the aim of providing optimal workload distribution on the server units in order to minimize the power consumption. The optimal schedules can provide optimal or close to optimal workload distribution on the server units. The optimization can take into account variations in the workload over a long period of time, for example, during one or more days or weeks in order to optimize the energy consumption. The schedules include an optimal workload distribution for each of the server units for a time period ahead in order to reduce the power consumption of the data center. The workload distribution on the server units are controlled based on the schedules for the workload. For example, power can be reduced by gathering the execution of several tasks on server units located in the same area, instead of distributing them over a large area, so that each of the server units will have a low workload. Thus, the cooling can be focused in one area housing highly loaded server units, and the cooling can be reduced or even turned off in other areas of the data center where the server units are idle. This is especially suitable, for example, during periods when the total load on the data center is low, such as during the night. It may be advantageous to turn off the idle servers. Idle servers may consume over 40% of their full power and by that wasting a high amount of energy. Thus, even more energy can be saved by turning off servers that does not have any scheduled tasks.

According to an aspect of the invention, the closed loop control of the load allocation comprises stopping and resuming execution of the tasks on the server units based on the schedules for the workload. If the total load on the data center is high, it is advantageous to pause some low prioritized task and to continue to execute the task during a time period with lower total workload and by that reduce the power consumption of the cooling system. For example, if the workload on a server unit is high, meaning that there is a queue of tasks waiting for execution, in order to shift work load on time, this embodiment allows the queue to grow up until the time period with lower workload or limitations on the execution time are met. Doing this reduces the power consumption of the data centre.

According to an aspect of the invention, the method comprises receiving flow measurements from a plurality of flow sensors distributed in the area, and performing the multi-objective optimization based on the flow measurements. For example, the sensors measure the air flow around the racks including the server units. Thus, the optimization will consider the current flow rate of the cooling medium at the server units and by that it is possible to improve the optimization.

According to an aspect of the invention, the method comprises receiving measurements from a plurality of humidity sensors distributed in the area and performing said multi-objective optimization based on received measurements of the humidity. The humidity in the data center affects the cooling of the server units. Further, decreasing the temperature if the humidity is high, may cause condensation of the moist air, which is bad for the server units. By carrying out the optimization with regard to the humidity in the area, condensation can be avoided.

According to an aspect of the invention, the multi-objective optimization results in a plurality of optimal numerical solutions and the method comprises automatic selection of one optimal numerical solution among the plurality of optimal numerical solutions based on a predefined objective. In case when objective functions are conflicting there exist no single solution to the multi-objective optimization problem, which simultaneously optimizes each of the objectives, i.e. optimizing the total power consumption of the cooling system, optimizing the workload on the server units, and optimizing the thermal conditions for the server units. In this case optimization will provide a plurality of alternative optimal solutions, i.e. a number of Pareto optimal solutions. The number of solutions can be many. In that case, one of the Pareto optimal numerical solutions can be automatically selected based on a predefined objective.

According to an aspect of the invention, the predefined objective is to optimize the total power consumption in the data center. This means that the Pareto solution with lowest power consumption is selected.

As a result of solving the multi-objective problem, multiple Pareto optimal solutions with respect to power consumption and output temperature are obtained. Optimal workload allocation, which is solved in case it is possible to freely locate the workload, has a single optimal solution which can be used later on for optimizing the other two objectives.

According to an aspect of the invention, the multi-objective optimization is performed based on a numerical optimization model, including a model for the geometry of the data center including the number of server units, physical locations of the server units and the cooling system, and a thermal model defining the interaction between the cooling system and the temperature and flow rate of the cooling medium at the server units including the limitations of the allowed temperatures at the server units.

According to a further aspect of the invention, the object of the invention is achieved by a computer program directly loadable into the internal memory of a computer or a processor, comprising software code portions for performing the steps of the method according to the invention, when the program is run on a computer. The computer program can be provided on a non-transitory computer readable medium, or through a network, such as the Internet. The non-transitory medium includes all computer readable media, with the sole exception being a transitory propagating signal per se. A non-transitory computer readable medium may include removable and non-removable storage devices including, but not limited to Read Only Memory (ROM), Random Access Memory (RAM), Compact Discs, CDs, Digital Versatile Discs, DVD, etc. According to another aspect of the invention, this aim is achieved by a system for controlling power consumption of a data center as defined in claim 12.

The system comprises:

- a data storage storing workload profiles for tasks executed on the server units, and- a computing unit configured to receive temperature measurements from the temperature sensors, to receive current workload for one or more of the server units, and to perform a multi-objective optimization including simultaneously optimizing the total power consumption of the cooling system, optimizing allocation of the workload on the server units, and optimizing the thermal conditions for the server units based on the temperature measurements, the current workload on the server units, the workload profiles, constraints for load allocation of the server units, and limitations of allowed temperatures at the server units, and to perform closed loop control of the cooling system and the workload on the server units based on the result of the multi-objective optimization.

According to an aspect of the invention, the computing unit is configured to generate reference values for the output temperature and the flow rate of the air/liquid flow output from the cooling unit based on the result of the multi-objective optimization.

According to an aspect of the invention, the computing unit is configured to calculate an optimal distribution of the workload on the server units and to generate orders for redistribution of the workload on the server units based on the result of the multi-objective optimization.

According to an aspect of the invention, the computing unit is configured to provide schedules for the workload on the server units for a time period ahead, and to generate orders for stopping and resuming execution of the tasks on the server units based on the schedules for the workload based on the result of the multi-objective optimization.

According to an aspect of the invention, the data center comprises a plurality of flow sensors distributed in the area and the computing unit is configured to receive flow measurements from the flow sensors, and to perform the multi-objective optimization based on the measurements of the flow.

According to an aspect of the invention, the data center comprises a plurality of humidity sensors distributed in the area and the computing unit is configured to receive measurements from the humidity sensors, and to perform the multi-objective optimization based on received measurements of the humidity.

Brief description of the drawings

The invention will now be explained more closely by the description of different embodiments of the invention and with reference to the appended figures.

Fig. 1a       shows a first example of a data center and a system for controlling the power consumption of the data center according to the invention.
Fig. 1b       shows a second example of a data center and a system for controlling the power consumption of the data center according to the invention.
Figs. 2a-c    show examples of workload profiles.
Fig. 3        shows a flow chart illustrating an example of a method for controlling power consumption of a data center according to the invention.
Fig. 4        shows one example of a digital data center map with information on temperature and workload at a server unit.
Fig. 5        shows another example of a digital data center map with information on temperature and workload at a server unit.
Fig. 6        shows another example of a digital data center map with information on temperature and workload at a server unit.

Detailed description

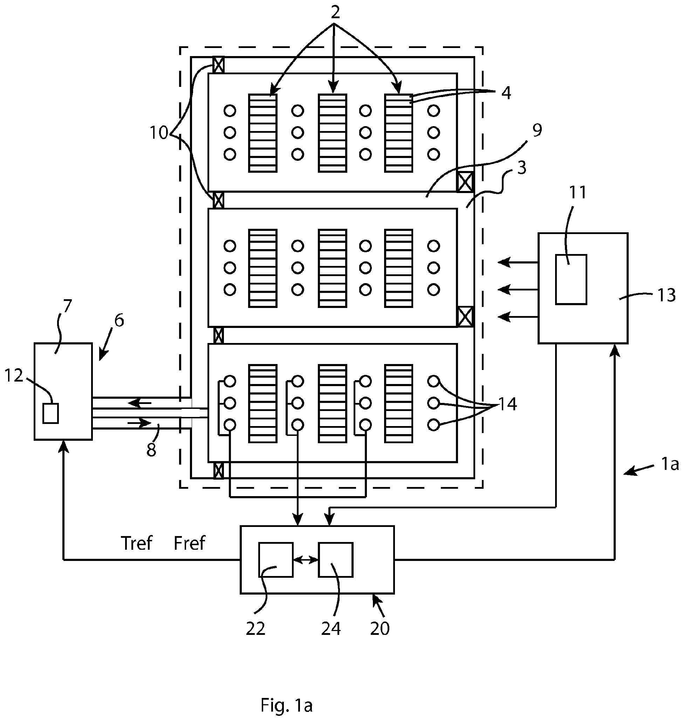

Figure 1a shows a first example of a data center and a system 1a for controlling the power consumption of the data center. The data center comprises a large number of racks 2 disposed in an area 3. The racks 2 are arranged in a plurality of rows. Each rack 2 includes a plurality of server units 4. The server units 4 are units including necessary hardware and software for executing software applications, such as memory, CPUs, and communication interfaces. The server units 4 are, for example, computers. Suitably, one or more of the server units 4 comprises virtual machine being installed on the server units. There are defined constraints on the temperature of the server units, such as minimum and maximum temperatures. The data center comprises a cooling system 6 for cooling the server units including a cooling unit 7 for producing a flow of a cooling media, such as air and/or a liquid, and a distribution network 8 for distributing the cooling media to the racks 2 including the server units. The cooling system 6 is, for example, a computer room air conditioning (CRAC) unit. The distribution network 8 includes a plurality of pipes 9 arranged between the rows of racks 2 for supplying the cooling media to the racks. The cooling system is able to vary the cooling of the racks by varying the temperature and flow rate of the cooling media.

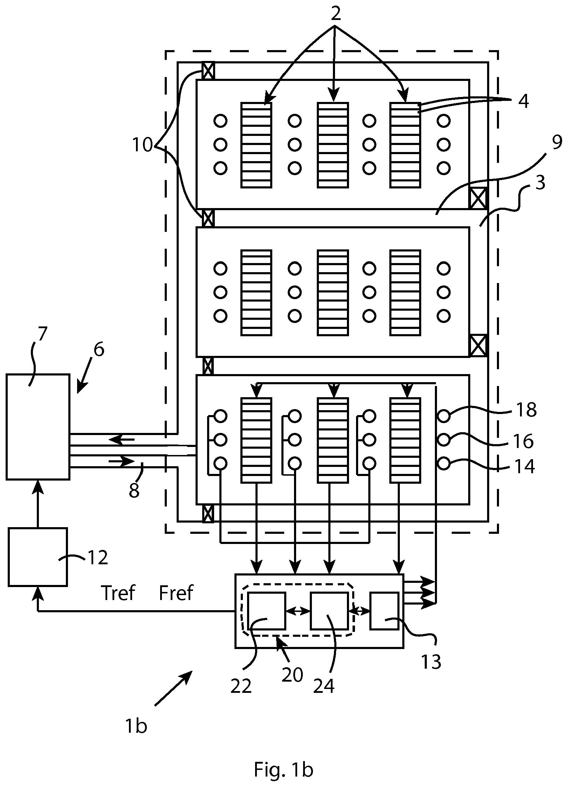

The cooling system may also include controllable valves 10 arranged so that the distribution of the cooling medium can be controlled in different areas of the data center and accordingly, the amount of cooling can vary between different parts of the data center, and thus between different racks. The data center may further comprise a cooling controller 12 including hardware and software for controlling the temperature and flow rate of the cooling medium from the cooling system 6. The cooling controller 12 controls the output temperature and flow rate of the flow from the cooling unit 7 in response to a reference temperature and a reference value for the flow rate. The cooling controller 12 may also control the flow rate in the pipes 9 by controlling the controllable valves 10 in the distribution network 8. Thus, the cooling controller 12 can separately control the cooling in different parts of the area of the data center. The cooling controller 12 can be integrated in the cooling unit 7, as shown in figure 1a, or be a separate unit as shown in figure 1b.

The data center illustrated in figure 1a comprises a sensor network including a plurality of temperature sensors 14 distributed in the area 3 for measuring the temperature in different parts of the area. Suitably, there is at least one temperature sensor disposed at each rack, or in close vicinity of each of the racks. The temperature sensors are configured to measure the temperature at the racks, and accordingly at the server units. The temperature sensors can be any known type of digital temperature sensor.

Figure 1b shows a second example of a data center and a system for controlling the power consumption of the data center according to the invention. Optionally, the sensor network may also comprise a plurality of flow sensors 16 distributed in the area to provide flow measurements on the cooling medium, as shown in figure 1b. The flow sensors are configured to measure the flow rate of the cooling medium at the racks and accordingly at the server units. Suitably, there is at least one flow sensor disposed at each rack, or in close vicinity of each of the racks. Optionally, the sensor network may also comprise a plurality of humidity sensors 18 distributed in the area to provide measurements of the humidity in different areas of the data center, as shown in figure 1b. Suitably, there is at least one humidity sensor disposed at each rack, or in close vicinity of each of the racks.

The data centers illustrated in figure 1a and 1b also comprise a data center controller 13 configured to control the distribution of the workload on the server units. With workload is meant the load on the processor of the server unit, e.g. the CPU load. The workload is usually given as a percentage of the maximum possible load on the processor of the server unit. For example, an idle server unit has a load of 0%, and a fully utilized server unit has a workload of 100%. The workload on a server unit depends on the number of tasks executed on the server unit and the type of the tasks. Optionally, a large job can be divided into a number of tasks executed on different server units. Some tasks can be executed for a limited period of time, for example, a calculation performed once. Other tasks are executed continuously, during an unlimited period of time, such as running business systems for banks and stores, or systems providing shopping on the Internet. The data center controller 13 comprises, according to some aspects, a task manager 11 that distributes workload between the server units. There may exist constraints on some of the server units. For example, some of the server units can be dedicated for execution of certain tasks. Another example is that the allowed workload is lower on certain server units if they are located in areas of the data center which is easily over heated. The data center controller 13 has, according to some aspects, information about the workload on each of the server units 4. The information can be both scheduled workload, with the workload extracted from workload profiles of the tasks assigned to the server units and actual workload on the server units received from the server units. The server units may continuously report their current workload to the data center controller or the data center controller may request the information when required.

In one aspect, the data center controller 13 is also configured to control the power supply to the server units. In another aspect, the data center controller 13 is able to switch on and off the server units. As discussed in the summary, idle servers can consume over 40% of their full power. In other words, server units with no running tasks may spend 40% of their full power. So, according to some aspects, the data center controller switches off server units that are idle to further reduce power consumption. Since the power consumption is decreased so much when switching off a server unit, it may be beneficial to allocate tasks such that as many server units as possible are idle and can be powered off and use server units that are located in the vicinity of each other to localize the cooling there. The possibility to do this will of course depend on the number of task that needs to be run and when they need to be run.

The example system illustrated in figures 1a and 1b for controlling the power consumption, further comprises an optimization unit 20 configured to compute an optimal workload distribution on the server units and an optimal temperature and flow rate of the cooling unit 7 in order to reduce the energy consumption of the data center. The optimization unit 20 comprises hardware, for example, a computer, and software for carrying out the optimization when executed on the computer. The optimization unit 20 comprises a data storage 22 for storing workload profiles for tasks to be executed on the server units, and a computing unit 24 configured to carry out the optimization. The computing unit 24 may include a processor, for example, one or more CPUs, for executing the software carrying out the optimization. The data center controller 13 and optimization unit 20 may be implemented as one single unit as shown in figure 1b, or as separate units as shown in figure 1a.

It should be noted that, according to an alternative embodiment, the data center controller 13, the optimization unit 20 and/or the cooling controller 12 may be implemented as one single unit.

A workload profile for a task is the estimated workload on the server unit during execution of the task. The workload profiles extend over a period of time, and may include variations in the workload during a day or during a week. For example, for some tasks the workload is higher during the day than in the night, or vice versa. The workload can also vary over the week. For example, the workload profiles are determined based on predictions of the workload on the server units during the execution of the tasks and/or based on measurements of the actual workload on a server unit during execution of the task. The workload profiles are preferably determined before start of the multi-objective optimization. However, the workload profiles can be repeatedly updated based on the actual workload on the server units during execution of the tasks. Preferably, the workload profiles cover the workload during at least 24 hours. More preferably, the workload profiles cover the workload during a longer time period, such a week or a month. For example, for some tasks the workload differs significantly between weekdays, weekends, working days and holy days. The workload profiles of all tasks that are to be performed at the data center represent the total workload demand on the server units.

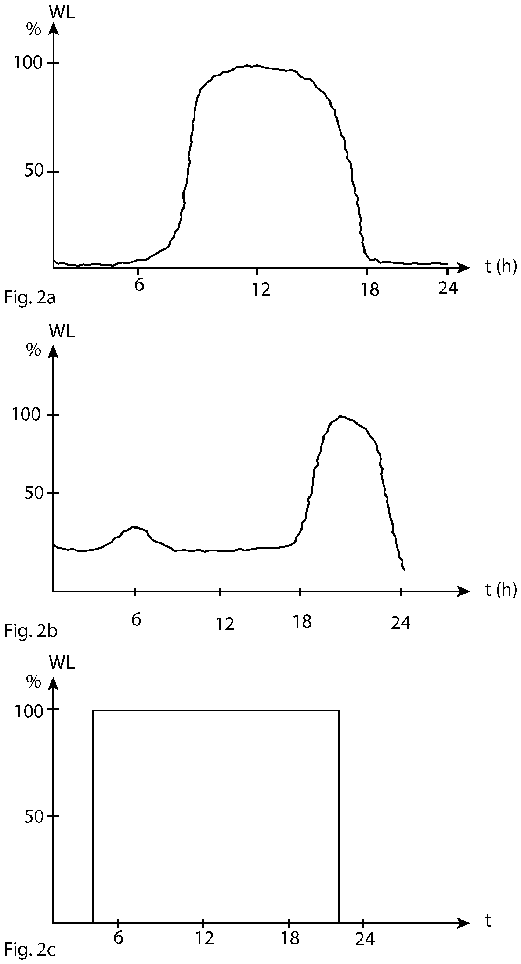

Figures 2a - 2c show examples on workload profiles. The workload (WL) is illustrated in % as a function of time during 24 hours, t(h). Figure 2a shows an example of a workload profile for a task having a high workload during the day and low workload during the night. This is, for example, for tasks supporting workplaces having working hours between 8 am and 5 pm. Figure 2b shows an example of a workload profile for a task having a peak in the workload in the morning and in the evening. This is, for example, for tasks supporting the entertainment industry, such as social media and Video-on-command. Figure 2c shows an example of a workload profile for a task requiring high workload until it is finished. This is, for example, a computational task. During execution of the task, the workload is 100%, and when the task has been finished, the workload is 0%. Such tasks are often not dependent on when they are executed, and can be executed during the night when the total workload on the data center is lower than during the day.

The optimization unit 20 receives information on the thermal status of the data center through the sensor network. The sensor data may be received by wire from the sensors or wirelessly, depending on what sensors are used. The information is used in a multi-objective control algorithm which calculates control signals for redistributing the cooling and computing power in the data center and reallocates workload on the server units for minimizing total power consumption. In one aspect, the multi-objective control algorithm may also calculate control signals for handle settings of power equipment in the data center.

As seen in figure 1a-b, the optimization unit 20 may be connected to the sensor network and receive measurements from the sensors through the sensor network. The optimization unit 20 receives temperature measurements from the temperature sensors 14. Optionally, the optimization unit 20 also receives flow measurements from the flow sensors 16 and humidity measurements from the humidity sensors 18. The optimization unit 20 receives information on the current workload of the server units 4 from the data center controller 13. The optimization unit 20 may further receive information on the predefined constraints for load allocations of the server units from the data center controller 13. The optimization unit 20 may also receive information on the limitations of allowed temperatures at the server units from the data center controller. Alternatively, the information on the limitations of allowed temperature of the server units can be stored on the data storage 22.

The computing unit 24 is configured to perform a multi-objective optimization based on the received temperature measurements, the current workload on the server units, the workload profiles, constraints for load allocation of the server units, and constraints for the temperature at the server units. Optionally, the multi-objective optimization is based on constraints on the flow rate of the flow of the cooling media. Further, the multi-objective optimization can be based on constraints for allocation and shifting of the workload on the server units. The optimization unit is configured to calculate a set of control sequences which involves multiple objective functions designed to, but not limited to, optimize the total power consumption, workload allocation and shifting, as well as temperature at the data center. A multiple-objective function or a set of single objective functions as well as their combinations can be formulated to solve an optimization problem.

The multi-objective optimization includes simultaneously optimizing the total power consumption of the cooling system, optimizing the workload on the server units, and optimizing the thermal conditions for the server units. The multi-objective optimization may be performed based on a numerical optimization model including a model for the geometry of the data center comprising the number of racks, physical location of the racks and position of the cooling system, and a thermal model defining the interaction between the cooling system and the temperature at the server units. The thermal model may include the limitations of the allowed temperatures at the server units. The decision variables of the multi-objective optimization are temperature and flow rate of cooling medium output from the cooling unit and the workload distribution on the server units of the data center. Optionally, the optimization unit 20 performs the multi-objective optimization based on received flow measurements and based on received measurements of the humidity.

The multi-objective optimization calculates optimal setting for the cooling system, such as reference values for the temperature and flow rate output from the cooling system, and optimal workload distribution among the server units in the data center both in space and time. The multi-objective optimization may result in a plurality of optimal numerical solutions, also denoted Pareto optimal solutions. In such a case, the computing unit 24 is configured to automatically select one Pareto optimal solution among the Pareto optimal solutions based on a predefined objective. Preferably, the computing unit 24 is configured to select the Pareto optimal solution minimizing the power consumption.

Pareto optimal solutions to the optimization problem contain optimal settings for the cooling system. The computing unit 24 is configured to calculate optimal reference values for the temperature (Tref) and flow rate (Fref) for the cooling unit 7 based on the selected Pareto optimal solution, and to send the reference values to the cooling controller 12 that controls the cooling unit 7 based on the received reference values, as seen from figure 1b. Thus, the computing unit 24 is configured to perform closed loop control of the cooling system 6 based on the selected Pareto optimal solution. The closed loop control of the cooling system comprises automatically controlling temperature and flow rate of the cooling system based on the selected Pareto optimal solution; the solution being based at least on measured actual temperature such that the loop is closed. In one aspect, the computing unit 24 is configured to generate control signals to the valves 10 to control the flow in the pipes 9 based on the selected Pareto optimal solution.

The computing unit 24 is further configured to perform closed loop control of the distribution of workload on the server units based on the selected Pareto optimal solution. The closed loop control is based on the optimization of flow rate, temperature and workload distribution. The computing unit 24 is configured to calculate an optimal distribution of the workload on the server units based on the result of the multi-objective optimization. In one aspect, the computing unit 24 is configured to provide schedules for the workload on the server units for a future time period based on the selected Pareto optimal solution. For example, the schedules cover the following 24 hours. The length of the time period of the schedules may depend on the time covered by the workload profiles. The computing unit 24 is configured to send the schedules for the workload to the data center controller 13 that controls the distribution of the workload on the server units based on the received schedules. The data center controller 13 can, for example, re-allocate the execution of some tasks to other server units according to the received schedules. Thus, the closed loop control of the workload comprises redistributing the workload on the servers based on the calculated optimal distribution of the workload; where the calculation takes actual workload into account. The schedules may also include instructions to postpone the execution of a new task for a while during a time period of expected high workload and to resume the execution of the task when the workload is expected to decrease. The data center controller 13 is configured to postpone execution of the tasks on the server units based on the instructions in the schedules for the workload. The computing unit 24 is further configured to repeat the optimization calculations and provide new schedules for the workload. For example, the optimization calculations may be repeated every hour, every day, or once a week. The interval for performing new optimization calculations is, according to some aspects, dependant on the size and structure of the data center. There may be data centers where the workload does not change that much over time and where the same tasks are performed repeatedly. In such a data center, it may suffice to perform the optimization calculations a number of times when setting up the system to set the schedules and then the system can use the same settings over and over again.

It is advantageous to have a digital map showing server units which can be used for computations in case when it load is moved. In order to move the workload from one server unit to another server unit it is advantageous to have a virtual machine being installed on that server. For example, a digital map showing moveable virtual machine locations can be used to define the movable workload.

In one aspect, the system 1a-b for controlling the power consumption can also be configured to switch off and on the server units based on the result of the optimization and by that reduce the power consumption of the data center. As previously discussed, when the server units are switched off they only consume 40% of energy in comparison with a 100% busy server. By moving the execution of some tasks to other server units, it is possible to switch off some of the server units and by that reduce the power consumption.

The system for controlling the power consumption provides workload allocation. Workload allocation may comprise workload shifting, which is the procedure when tasks are shifted in time and/or some tasks are prioritized in case of a peak of power consumption and some tasks are postponed for some time until more resources is available. Then that task is resumed. Workload allocation is, in other words, allocation of workload of the physical workload distribution on the server units and/or timewise allocation of workload.

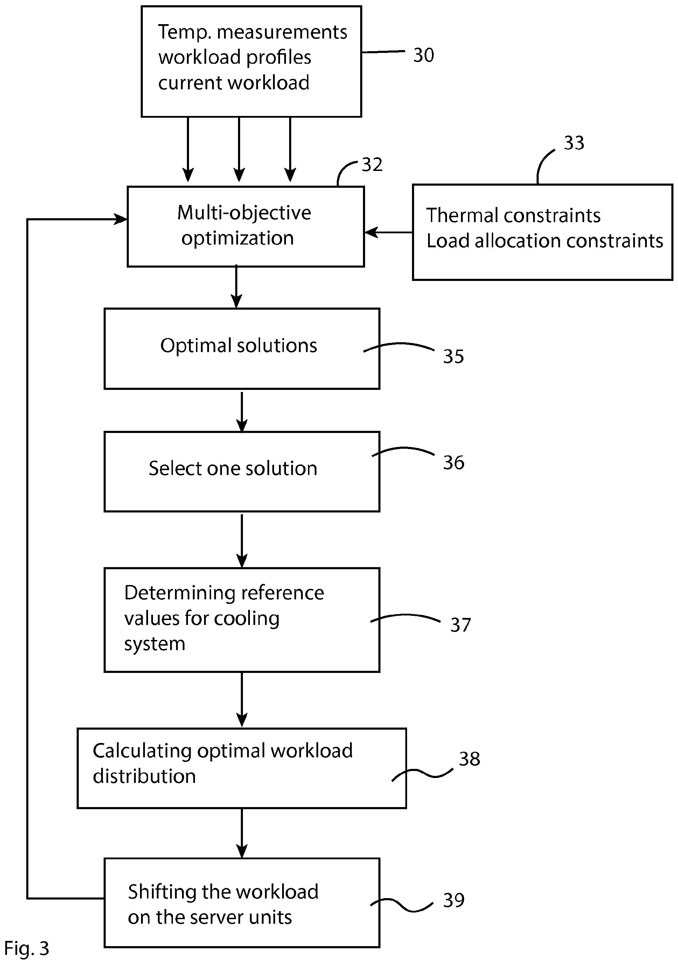

Figure 3 shows a flow diagram illustrating an example of a method and a computer program product for controlling power consumption of a data center. It will be understood that each block can be implemented by computer program instructions. The method is based on a multi-objective control algorithm, which calculates control signals for cooling and workload on the server units in the data center.

The method comprises retrieving or receiving the workload profiles for the tasks executed on the server units or to be executed on the server units, receiving temperature measurements from the temperature sensors 14 distributed in the data center and receiving information on the current workload on one or more of the server units, block 30. For example, information on the current workload on all server units is received. The method may also comprise receiving flow measurements from the flow sensors, and/or receiving measurements from the humidity sensors.

The method further comprises performing a multi-objective optimization including simultaneously optimizing the total power consumption of the cooling system, optimizing the workload on the server units and optimizing the thermal conditions for the server units, based on the temperature measurements, the current workload on the server units, the workload profiles, constraints for load allocation of the server units, and limitations of allowed temperatures at the server units, block 32 - 33. The multi-objective optimization also considers limits on maximum allowed workload on each of the server units, which is a constraint for the workload. The decision variables of the multi-objective optimization are temperature and flow rate of cooling medium output from the cooling unit and the workload distribution on the server units of the data center. The multi-objective optimization can also be performed based on the flow measurements and/or the humidity measurements. A multi-objective optimization problem is solved subject to a set of constraints such as constraints on temperature and flow rate, constraints on workload and its reallocation, power limits, data center topology, and operation of the cooling system and power equipment.

The multi-objective optimization is performed based on a numerical optimization model including a model for the geometry of the data center including the number of racks, physical location of the racks and physical location of the cooling system, and a thermal model defining the interaction between the cooling system and the temperature at the server units. The thermal model includes the limitations of the allowed temperatures at the server units or racks. The thermal model may also include constraints of the flow rate. The numerical optimization model may also include maximum allowed workload on each of the server units.

The multi-objective optimization may result in a plurality of optimal numerical solutions, denoted Pareto optimal solutions, block 35. Each Pareto optimal solution represents a scenario of the thermal conditions and the load distribution on the server units. In one aspect, the method comprises automatic selection of one Pareto optimal solution among the plurality of Pareto optimal solutions based on a predefined objective, block 36. Alternatively, an operator may select one of the optimal solutions. According to some embodiments, the predefined objective is to minimize the total power consumption in the data center.

In one aspect, a set of sequences which involves multiple objective functions designed, but not limited, to optimize the total power consumption, workload allocation as well as temperature and air flow at the data center are calculated. One multiple-objective function or a set of single objective functions as well as their combinations could be formulated to solve the optimization problem. Depending on the formulation of the optimization problem, solution to the multi-objective optimization could be presented either by the Pareto frontier representing compromise solutions for each objective function, or as an optimal solution to the single optimization problem. Multidimensional Pareto frontier includes a set of Pareto optimal solutions for conflicting objective functions defined by the optimization. This set could include the optimal solutions to the single objective optimization problems, too. The optimal Pareto frontier gives the possibility to choose a distinct solution according to the user's choice as well as analyze different Pareto optimal solutions. As an example, solutions corresponding to the lowest total power consumption only or solutions corresponding the lowest possible total power and allowing to the maximal possible temperature can be selected and analyzed.

This functionality could be used, but is not limited, to long term prediction, planning and analyses based on the dependency of the workload versus total power consumption or short-term optimization of total power consumption versus instant workload throughput.

A Pareto set could include, but is not limited to, the optimal workload allocation, Pareto optimal power consumption and output hot aisle temperature. Optimal workload allocation may be identified by applying the heuristic rule for movable workload and available servers. Heuristics is based for example, on investigation of a digital workload map and/or workload pattern and/or individual server power consumption. Optimal solutions to the single objective problems take into account one objective function and thus represent a single optimal solution.

The method further comprises performing closed loop control of the cooling system and the workload on the server units based on the selected solution to the multi-objective optimization problem. The method comprises determining reference values for the cooling system, such as reference values for the temperature and the flow rate of the cooling media, block 37. The temperature and flow rate of the cooling system can be automatically controlled based on the determined reference values.

The closed loop control of the cooling system may also comprise calculating an optimal workload distribution on the server units based on the selected solution to the multi-objective optimization problem, block 38. The closed loop control of the workload comprises redistributing the workload on the servers based on the optimal distribution of the workload, block 39. This includes automatically performing re-allocation of the workload between the server units to achieve the optimal distribution of the workload. The closed loop control of the load allocation may also comprise postponing execution of new tasks based on the selected solution to the multi-objective optimization problem.

To be able to move the workload from one server to another server, the movable workload on the server units, i.e. the workload that is allowed to be moved, should be known. The movable workload can be defined in different ways. For example, digital workload maps illustrating the moveable workload on the server units can be used to define the movable workload. In one aspect of the invention, the multi-objective optimization is performed based on the available movable workload on the server units, for example, based on the digital workload maps.

In one aspect, the method comprises providing schedules for the workload on the server units for a future time period based on the result of the multi-objective optimization, and controlling the workload on server units based on the schedules for the workload.

According to another aspect of the invention, the system may generate an integrated digital data center map of the workload on the server units and thermal and operational status of the data center. This aspect of the invention provides a new way to display information about the workload integrated with the information about the thermal and operation status.

Hot spots and overcooling originate from uneven workload distribution on the server units. However, there is a problem that workload information is not well monitored and represented in the Data Center Infrastructure Management, DCIM, where the functions in the above system may be managed and overviewed. Visualization of information related to idle server units and powered off servers may be introduced. It may give a visual indication of how efficiently the data center uses energy, equipment and computing resources. The information from the data analytics for the main data center parameters as temperature, workload, CPU usage, number of Virtual Machines, VM, may be incorporated.

The conventional way to display information in software for monitoring data centers is to display thermal information of the data center with colours. Thus, a 2 or 3-dimensional representation of the data center is used for grading the temperature of the servers and rack-servers. Also, numerical information about temperature can be included in the drawing. These drawings only provide information about temperatures, thus allowing for hot spots and overcooling situations to be identified.

Virtualization techniques of the server units allow to separate resources, for example, memory allocation and hard disks space between different applications by means of virtual machines (VM). As a consequence, each virtual machine is considered as a new server unit with its own operating system and separate resources which can be physically reallocated to different server units.

A hypervisor or a virtual machine monitor is a computer software, firmware, or hardware that creates and runs virtual machines. This virtualization principle opens up new possibilities for optimizing data centers with respect to optimal energy consumption and efficient usage of other resources as servers, CPU units and memory because the hypervisor can manage virtual machine start-up and shut down, or migrate virtual machines to other servers.

Therefore, on-line monitoring of workload, workload migration and monitoring of parameters related to this information become important in the next level DCIM and advanced control.

An integrated data center digital map visualizing both in colours and digitals is proposed. The data center digital map may include the following features:

- Configuration allowing to specify the relevant information for operating the data center. Such a configuration includes but is not limited to:

  ◦ On-line workload monitoring and visualization map with colours and resource (power and CPU) utilization illustrated for each server rack, or even on each server.
  ◦ A digital map showing moveable VM locations, i.e. the locations of the VM which are allowed to be moved, their workload and available server units for moving workload.
  ◦ A map showing workload prediction for each server based on historical workload analysis.
  ◦ A map showing rack -level power consumption.
  ◦ A heat map showing hot spots and overcooling areas.
  ◦ A map showing thermal status, rack temperatures, rack inlet temperatures, rack outlet temperatures, Computer Room Air Conditioner/Computer Room Air Handler (CRAC/CRAH) flow rates, supply air temperature, cooling water temperature and humidity.
  ◦ A map showing IT and cooling unit operation status (on, off, idle).
  ◦ A map showing tenants.
  ◦ A map showing data center power devices operation status, parameters and on-line power data.
  ◦ History maps showing previous maps.
  ◦ Digital maps showing analytical results of data analysis, for example, average, Max and Min values for temperature, workload, CPU usage, number of VM, etc.

- The map is connected to control, simulation and optimization modules and a separate map will show results coming from these modules.
- The digital map can be uploaded and monitored on the computer as well as through a smart phone or tablet any time.

The map provides several benefits such as:

- A user friendly visual tool for operators to monitor activities at data centers.
- Increased functionality allowing to see all key information about the data center.
- The map can be used as a tool for advanced control for energy saving and operation.

The virtualization techniques require new ways of displaying information regarding workload virtualization integrated with the data center thermal status and other data center operation information listed above. Workload virtualization includes, but is not limited to, the number of virtual machines (VM), number of applications, CPU load at each server as well as percentage of workload which is possible to shift to another server.

The conventional thermal status of the data center displayed using two or three-dimensional drawing is not enough to describe the operation condition of the data center. The flexibilities introduced by the virtualization techniques for reallocating the workload open new opportunities for improving the efficiency data center energy consumption. New methods are suggested for displaying integrated information regarding thermal status, workload virtualization and server operations.

The data center information listed above, for example, workload virtualization, can be incorporated in the two or three-dimensional digital map in several ways combining multivariable information in the drawing. For example, opacity in the server drawing could indicate the degree of virtualization. Thus, a solid colour indicates that the workload cannot be reallocated and transparency indicates a high level of virtualization, which means that the workload can be reallocated.

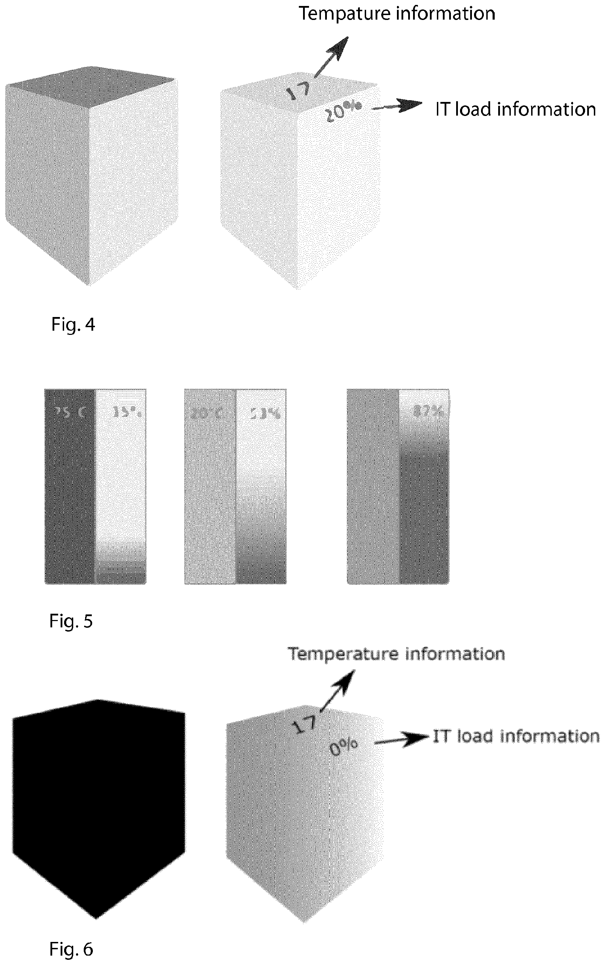

Figure 4 shows one example of a digital data center map with information on temperature and workload at a server unit. The degree of opacity indicates the degree of virtualization. Left side illustrates low level of virtualization, and right side illustrates high level of virtualization.

Figure 5 shows another example of a digital data center map with information on temperature and workload at a server unit. Another option could be to dedicate half of the rack drawing for temperature and half of the rack drawing for the workload virtualization, as see in figure 5. Also, the information about the rack activity can be included, as it is shown in figure 6.

Figure 6 shows another example of a digital data center map with information on temperature and workload at a server unit. A black server-rack indicates an off server-rack and a grey rack indicates an idle rack. This general drawing will show in one screen all relevant information for operational management. This information is dynamically changing with the sample period defined by the monitoring system.

One possible configuration for the digital map follows below.

A higher-level map, similar to Fig. 1a or Fig. 1b, may illustrate general information about the data center including geometry (position of racks, CRAC elements, etc.) and possibly also temperature in the room, humidity, and Computational Fluid Dynamics (CFD) model for air flow. Additionally, information associated with each rack, such as rack temperatures (both sides), state (on, off, idle), servers dedicated to a specific tasks and percentage of total workload that can be reallocated may be displayed. This information is visualized by different colours for the flow, thermal information, state and opacity for each rack. Workload and in-out rack temperature for each rack may be visualized with digital information.

A lower level map may visualize any information associated with each server respectively. The temperature at each server unit, CPU load, fan speed, number of virtual machines, number of applications, whether the server is dedicated to a specific task, percentage of workload that can be reallocated are visualized by numbers (both integers and percentage).

The map illustrating the information about the prediction of the workload for each server shows the dynamic behaviour of the workload based on the type of application running on the VM. For example, scientific applications including heavy computations have constant CPU demand over a long time. Banking applications or e-commerce have periodically changing CPU demand. On-line streaming applications have well defined peaks during the night time.

Once the user clicks on one specific server-rack, information about each server on the server-rack may be displayed by the corresponding lower level map.

Listed data center data and information in the maps are communicated on-line through a data base and history data storage. These lower level maps can be visualized with 3D rotation. Operators can easily select and view any map to check operation status of the server units.

## Example

In the following, a detailed example on how to carry out the invention will be described.

## Part I Problem definition

The problem under consideration is to optimize the multi-objective function including the total power consumed by the data center (DC), maximize the outlet aisle temperature and optimize the IT load allocation. Two alternative multi-objective optimization (MOO) formulations are considered.

### 1 MOO Formulation 1

In the first one, the formulation includes three objectives. The objective concerning the optimal IT load allocation is expressed in terms of minimization of the number of the server racks which are turned on:

$$\{min\{TotalPower\}, max\{OutletTemp\}, min\{NumberServerRacksOn\}\} \tag{1}$$

This formulation can be rewritten in a standard form like:

$$min\{ TotalPower( X ) , -OuletTemp( X ), NumberServerRacksOn \} \tag{2}$$

with the decision vector X:

$$X=[ ITLoadAllocation,CoolingUnitTemp,CoolingUnitAirFlow ] \tag{3}$$

Problem (2) - (3) is solved subject to the set of constraints:

- Upper Limit on the inlet temperature;
- Restrictions on the IT load allocation. Could be implemented in terms of the map showing the location of dedicated servers. This digital map shows also the region of influence of each cooling unit, e.g. Computer Room Air Conditioner/Handler (CRACH)
- Historical IT load profiles
- Cost of switching on/off servers
- Short-term demand (described below)
- CoolingPower >= Power Consumption of a server
- Constraint of the performance of the DC. Expressed in terms of the length of the queues of requests to be processed.

2 MOO Formulation 2

An alternative formulation does not include IT load optimization explicitly and represents the case when IT load allocation is predefined and can not be manipulated at all:

$$min\{TotalPower( Y ) ,-OutletTemp( Y ) \} \tag{4}$$

with the decision vector Y being a reduced version of decision vector (3), where the IT load allocation is excluded:

$$Y=[ CoolingUnitTemp,CoolingUnitAirFlow ] \tag{5}$$

Problem (4) - (5) is solved subject to the set of constraints described above with only the difference that the IT allocation constraint is not included.
Formulations (2) and (4) differ in terms of presence of the number of server racks turned on.

3 More on Objective Functions

To calculate objective functions in (2) and (4) it is required to have numerical models calculating:

- Power consumption of each server;
- Cooling power produced by cooling units;
- Thermal distribution produced by cooling units and influencing servers

**Part II Heuristic solution**

4 Notations and Assumptions

Heuristic solution is based upon the following notions:

**Input IT Load Info:**

1. Long-term prediction of the IT load demand over time using historical data, historical IT load profile. The time span could be between 1 day and 1 month (or even more), depending on the data center.
2. Short-term required IT load demand or instant or short-term demand. The sample time is not less than 15 min, it depends on the data center and the time span of the historical IT load profile.

**Look-up table:**

A look-up table including information about the maximum total power consumption of each server rack and even the combination of racks is used according to this example. To create this look-up table, the numerical models introduced in Section 3 should be in place.
This look-up table includes records on previous solutions calculated by optimization. As soon as a new solution is obtained it is added to the look-up table.
The records include the combination of the IT load allocation and optimal airflow and cooling rates. Update is done every time a new Pareto set is calculated and the preferred solution is identified.

**Digital Data Center map:**

A map, also referred to as digital map, including the information about the dedicated and "free" servers (servers which could be used for tasks) as well as other features.

**Zones of influence of cooling units:**

Each DC has a certain geometry so that the positions of the cooling units, such as Computer Room Air Conditioner (CRAC) units, are fixed. Each CRAC has its region of influence, a 2D region in the plane of rack inlets through which the cold air from the CRACs travels. Some server racks are situated in the regions of intersection of zones of influence of different CRACs, meaning that they are cooled more than other servers.
The DC geometry is an input to the optimization and prior to operations, the server racks are prioritized with respect to zones of influence. Firstly, the server racks placed in zones being cooled most of all are identified, then server racks in zones with next to the most intensive cooling are identified, etc. Finally, the racks in zones which are cooled the least are identified.

**Bin packing type problem:**

A type of problem similar to the bin packing problem aimed to minimize the number of bins by packing them maximally by the goods of different volumes subject to the maximum volume of each bin. In our case we consider each server rack as a bin. Maximum volume of each bin is the total number of servers in the bin. The problem in our case is to minimize the number of server racks while maximizing the number of servers turned on in each rack. This problem is solved using different heuristic approaches as Best Fit Decreasing, next Fit Decreasing, or other fast heuristics.

**Posterior MOO methods:**

Type of methods based on computation of the Pareto front representing the set of alternative solutions. After the Pareto set is calculated, it is up to the user to choose a particular solution.
Pareto front calculation or rather approximation could be done by different methods. One example is to use Normal Boundary Intersection (NBI) method, other are directed search domain, MOO particle swarm or evolutionary algorithms which could be used.
NBI method, for example, is based on the scalarization of the MOO which is done by introducing and solving a single optimization problem which solution is Pareto optimal.
Thus, the Pareto optimal set is constructed by solving a set of single objective optimization problems.
When the Pareto front is calculated, the next step is to involve a decision maker (DM) to choose one of the solutions or pre-define the choice of the solution in automatic mode, say choose the solution with the minimal total power consumption value.

**Solution of single optimization problem:**

Solution of a single optimization problem is a part of MOO solution as mentioned above. In this case we refer to the nonlinear nonconvex constrained problems showed using the gradient-based methods of optimization as for example, Primal-Dual Interior Point method.

**Queue Threshold value:**

The input parameter specified in the contract between the DC and customers. It reflects the maximum time delay or time interval when each task should be addressed. This parameter is used to check if it is required to utilize extra servers in case if delay is getting too large. If so, it means that shifting in time is not possible any longer due to the risk of delay of addressing requests. The tasks in that queue are rescheduled to another server.

**Scheduling Software:**

To control the DC, it is assumed that the dedicated software scheduling the requests is available. This kind of software is usually used in DCs and it should have the list of servers to be used for processing the requests as an input. This list will be generated by the optimization algorithm.

5 Algorithm Description

The algorithm below is used to solve both optimization problems. If the problem (2) - (3) is solved then all steps of the algorithm should be completed. If there is no possibility to control IT load allocation and problem (4) - (5) is solved instead, the algorithm in this case starts from step 3.

**1.** Initialization: Based on the long-term IT load prediction. The goal of this step is to minimize the number of server racks.
Initialization according to the long-term/historical prediction spanning the whole time interval of the long-term profile. All servers dedicated to some tasks which are scheduled for a given time period according to the long-term prediction, are set on. Almost all other servers inactive during some time periods are turned off. "Almost" means that there are extra reserved redundant servers addressing the scholastic component of the long-term prediction for IT load. This redundancy is defined internally by each DC.
The initial choice of the servers not dedicated to certain tasks are done by operators based on their common practice.
**2.** Optimal IT load Allocation: The goal is: based on short-term IT load demand to distribute the current IT load among servers which are turned on according to the previous step and define the tasks to be shifted in time. To read the short-term IT load demand the digital map can be used. All changes in IT load allocation are addressed by the digital map.
**2.1** Heuristics starts with the identification of the set of requests for the short-term demand which are dedicated to some predefined servers. In case there are these requests, they are scheduled to their dedicated servers. The algorithm for scheduling these tasks among dedicated servers is based on heuristic rule similar to bin packing problem. It is described in more details in the next item. Task distribution is done by utilizing the dedicated software for scheduling.
**2.2** The rest of tasks are scheduled according to the heuristic rule, too. This rule is based on the idea of maximum utilization of the all feasible servers in server racks located in the zones of highest influence of the CRAC units. The servers located in these zones have the most of cooling.
Doing so, the feasible servers should be determined as an intersection of the sets of servers which are allowed to be used (are turned on and are not dedicated/busy) and the server racks situated in the regions of highest influence of the CRAC units.
Scheduling of the short-term request is done on the servers located in zones defined above taking into account priorities of the servers. Priority of servers is defined by their locations, so that the servers located in zones of highest influence of cooling elements have highest priority. The length of the buffer, or the number of requests in the queues waiting for execution defines the time shifting for these requests.
If the length of the queue(s) is bigger than some threshold value, extra server racks are utilized to execute these tasks in the queue, see step 2.3.
Dedicated software for distributing the requests among the feasible servers is used for scheduling.
These heuristics are based on bin packing algorithm. The goal is to minimize the number of server racks used for operations by scheduling tasks to be executed on servers according to their priorities. Firstly, servers situated in zones of highest influence cooling units are used. If it is not enough to utilize all those server racks, extra server racks are chosen in the zones of next to zones of highest priority, etc. until all tasks are scheduled.

**2.3 Rescheduling:**

After scheduling, queues of tasks for each server are defined. Thus, approximated time for execution of tasks can be estimated. If this time is longer than the allowed time for execution of a task, the tasks in the queue should be rescheduled. This is done by utilizing extra servers according to their priorities.

The tasks in the queues are rescheduled starting with the first task waiting for execution or according to their max time for execution. This is defined by the DC operators.

The number of extra servers utilized depends on the size of buffer introduced above and on current workload of servers of high priority.

**3.** Minimization of total power consumption and maximization of hot aisle temperature is solved using the standard posterior methods of MOO.

Since optimal IT load allocation minimizing the number of servers switched on is identified on the previous step of the algorithm, the problem of optimization includes only two conflicting objective functions described by equations (4) - (5).

This problem is solved using some of the posterior type of the MOO algorithms producing Pareto front. Before the MOO is solved, the IT allocation settings is checked with the Lookup table. If this particular IT load allocation was already included in the table and constraints are satisfied, the optimal settings for the airflow and cooling rate or whole Pareto front are drawn from the table. This helps to skip resolving a MOO problem.

Posterior MOO algorithms include solution of the single optimization problems. In this case these problems are solved using standard methods on nonlinear constraint optimization as gradient based constrained methods. Objective functions are evaluated based on the linear or nonlinear models for power consumption of servers, cooling power and thermal models for cooling units. Pareto filtering and sampling is done according to the particular method of MOO used.

**4.** At the next time interval (which is the next time sample step), the short-term demand is addressed and algorithm starting from step 2 is repeated. Some adjustments might be required:

4.1 Some servers that should not be utilized or turned off according to long-term prediction can appear to be busy with previous requests due to rescheduling.

4.2 The algorithms check whether some of the servers are idle or not required to be used according to the long-term prediction, they are switched off.

The algorithm presented above is used for solving optimization problems (1). Problem (4) is a part of the first problem, thus the algorithm to use in this case is boiled down to step 3 only. In this case this step is repeated according to the sampling time

**Claims**

1. A method for controlling power consumption of a data center, the data center comprising a plurality of server units (4), distributed in an area of the data center, and a cooling system (6) for cooling the server units, wherein the method comprises:

   ○ storing workload profiles for tasks executed on the server units,
   ○ receiving temperature measurements from a plurality of temperature sensors (14) distributed in said area,
   ○ receiving current workload for one or more of the server units,
   ○ performing a multi-objective optimization including simultaneously optimizing the total power consumption of the cooling system, optimizing allocation of the workload on the server units, and optimizing the thermal conditions for the server units, based on:

   ■ the temperature measurements,
   ■ the current workload on the server units,
   ■ the workload profiles,
   ■ constraints for workload allocation of the server units, and
   ■ limitations of allowed temperatures at the server units, and

   ○ performing closed loop control of the cooling system and the workload on the server units based on the result of the multi-objective optimization.

2. The method according to claim 1, wherein the decision variables of the multi-objective optimization are temperature and flow rate of cooling medium output from the cooling unit and the workload distribution on the server units.

3. The method according to claim 1 or 2, wherein the closed loop control of the cooling system comprises automatically controlling temperature and flow rate of the cooling system based on the result of the multi-objective optimization.

4. The method according to any of the previous claims, wherein the method comprises calculating an optimal distribution of the workload on said server units (4) based on the result of the multi-objective optimization, and the closed loop control of the workload comprises redistributing the workload on the servers based on the calculated optimal distribution of the workload.

5. The method according to any of the previous claims, wherein the closed loop control of the workload comprises providing schedules for the workload on the server units (4) for a time period ahead based on the result of the multi-objective optimization, and controlling the workload on server units based on the schedules for the workload.

6. The method according to claim 5, wherein the closed loop control of the load allocation comprises postponing execution of the tasks on the server units (4) based on said schedules for the workload.

7. The method according to any of the previous claims, the method comprises receiving flow measurements from a plurality of flow sensors (16) distributed in said area, and performing said multi-objective optimization based on the flow measurements.

8. The method according to any of the previous claims, wherein the method comprises receiving measurements from a plurality of humidity sensors (18) distributed in said area, and performing said multi-objective optimization based on received measurements of the humidity.

9. The method according to any of the previous claims, wherein said multi-objective optimization results in a plurality of alternative Pareto optimal numerical solutions and the method comprises automatic selection of one optimal numerical solution among said plurality of alternative Pareto optimal numerical solutions based on a predefined objective.

10. The method according to any of the previous claims, wherein said multi-objective optimization is performed based on a numerical optimization model, including a model for the geometry of the data center including the number of server units, physical location of the server units and the cooling system, and a thermal model defining the interaction between the cooling system and the temperature at the server units including the limitations of the allowed temperatures at the server units.

11. A computer program directly loadable into the internal memory of a computer or a processor, comprising software code portions for performing the steps of the method according to any of the claims 1 - 10.

12. A system (1) for controlling power consumption of a data center comprising a plurality of server units (4) disposed in an area (3) a cooling system (6) for cooling the server units, and a plurality of temperature sensors (14) distributed in said area, wherein the system comprises:

- a data storage (22) storing workload profiles for tasks executed on the server units,
- a computing unit (24) configured to receive temperature measurements from the temperature sensors, to receive current workload for one or more of the server units, and to perform a multi-objective optimization including simultaneously optimizing the total power consumption of the cooling system, optimizing allocation of the workload on the server units, and optimizing the thermal conditions for the server units based on the temperature measurements, the current workload on the server units, the workload profiles, constraints for load allocation of the server units, and limitations of allowed temperatures at the server units, and the system (1) is configured to perform closed loop control of the cooling system (6) and the workload on the server units (2) based on the result of the multi-objective optimization.

13. The system according to claim 12, wherein the computing unit (24) is configured to generate reference values (Tref, Fref) for the output temperature and flow rate of a cooling medium output from the cooling unit based on the result of the multi-objective optimization.

14. The system according to claim 12 or 13, wherein the computing unit (24) is configured to calculate an optimal distribution of the workload on said server units (4) and to generate orders for redistribution of the workload on the server units based on the result of the multi-objective optimization.

15. The system according to any of the claims 12 - 14, wherein the computing unit (24) is configured to provide schedules for the workload on the server units (4) for a time period ahead based on the result of the multi-objective optimization, and to generate orders for stopping and resuming execution of the tasks on the server units based on said schedules for the workload.

Fig. 1a

Fig. 1b

Fig. 2a

Fig. 2b

Fig. 2c

Fig. 3

Tempature information

17

20%

IT load information

Fig. 4

Fig. 5

Temperature information

17

0%

IT load information

Fig. 6

Europäisches Patentamt
European Patent Office
Office européen des brevets

# EUROPEAN SEARCH REPORT

Application Number

EP 18 15 5578

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JING XU ET AL: "Multi-Objective Virtual Machine Placement in Virtualized Data Center Environments", GREEN COMPUTING AND COMMUNICATIONS (GREENCOM), 2010 IEEE/ACM INT'L CONFERENCE ON&INT'L CONFERENCE ON CYBER, PHYSICAL AND SOCIAL COMPUTING (CPSCOM), IEEE, 18 December 2010 (2010-12-18), pages 179-188, XP031923482, DOI: 10.1109/GREENCOM-CPSCOM.2010.137 ISBN: 978-1-4244-9779-9 * abstract * * page 179 - page 184 * * figures 1-3 * | 1-15 | INV. H05K7/20 G06F1/20 G06F9/50 |
| A | US 2003/193777 A1 (FRIEDRICH RICHARD J [US] ET AL) 16 October 2003 (2003-10-16) * paragraph [0016] - paragraph [0039] * * paragraph [0045] - paragraph [0055] * * figures 1A, 1B, 3 * | 1-15 | |
| A | US 2012/290862 A1 (BROWN GENE L [US] ET AL) 15 November 2012 (2012-11-15) * paragraph [0057] - paragraph [0080] * * figures 4-6 * | 1-15 | TECHNICAL FIELDS SEARCHED (IPC) G06F H05K |
| A | US 2012/180055 A1 (BRECH BRAD L [US] ET AL) 12 July 2012 (2012-07-12) * paragraph [0027] - paragraph [0051] * * figure 2 * | 1-15 | |
| A | US 2015/378414 A1 (KATO TAKESHI [JP] ET AL) 31 December 2015 (2015-12-31) * paragraph [0009] - paragraph [0027] * * paragraph [0058] - paragraph [0067] * * paragraph [0080] * * figures 1-3 * * claim 1 * | 1-15 | |

The present search report has been drawn up for all claims

| Place of search | Date of completion of the search | Examiner |
|---|---|---|
| The Hague | 15 June 2018 | Schmidt, Daniel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 15 5578

This annex lists the patent family members relating to the patent documents cited in the above-mentioned European search report.
The members are as contained in the European Patent Office EDP file on
The European Patent Office is in no way liable for these particulars which are merely given for the purpose of information.

15-06-2018

| Patent document cited in search report | Publication date | Patent family member(s) | Publication date |
|---|---|---|---|
| US 2003193777 A1 | 16-10-2003 | US 2003193777 A1<br>WO 03090505 A2 | 16-10-2003<br>30-10-2003 |
| US 2012290862 A1 | 15-11-2012 | NONE | |
| US 2012180055 A1 | 12-07-2012 | US 2012180055 A1<br>US 2013104136 A1 | 12-07-2012<br>25-04-2013 |
| US 2015378414 A1 | 31-12-2015 | CN 101556493 A<br>EP 2109028 A2<br>JP 4724730 B2<br>JP 5161277 B2<br>JP 2009252056 A<br>JP 2011040083 A<br>US 2009259345 A1<br>US 2015378414 A1 | 14-10-2009<br>14-10-2009<br>13-07-2011<br>13-03-2013<br>29-10-2009<br>24-02-2011<br>15-10-2009<br>31-12-2015 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **KUNIO FUKUMOTO ; NOBUYUKI TAMURA ; HIDEKI ISHIBASHI.** Optimization of IT load and facility energy in data centers. *Fujitsu Sci, Tech, J.,* October 2010, vol. 46 (4), 376-382

- **LUCA PAROLINO ; BRUNO SINOPOLI ; BRUCE H. KROGH.** Reducing data center energy consumption via coordinated cooling and load management. *HotPower'08 Proceedings of the 2008 conference on Power aware computing and systems,* 07 December 2008